# EUROPÄISCHE PATENTSCHRIFT

(11) **EP 1 709 691 B1**
(45) Veröffentlichungstag und Bekanntmachung des Hinweises auf die Patenterteilung: **23.07.2008**
(21) Anmeldenummer: 05700978.9
(22) Anmeldetag: 17.01.2005
(51) Int. Cl.: H01L 31/10, H01L 29/76

(54) **HALBLEITERSTRUKTUR**
SEMICONDUCTOR STRUCTURE
STRUCTURE A SEMI-CONDUCTEUR

(30) Priorität: 28.01.2004 DE 102004004283
(43) Veröffentlichungstag der Anmeldung: 11.10.2006
(73) Patentinhaber: MPG Max-Planck-Gesellschaft zur Förderung der Wissenschaften e.V., 80539 München (DE)
(72) Erfinder: LECHNER, Peter, 83607 Holzkirchen (DE); LUTZ, Gerhard, 81739 München (DE); RICHTER, Rainer, 81243 München (DE); STRÜDER, Lothar, 80803 München (DE)
(74) Vertreter: Beier, Ralph
(86) Internationale Anmeldenummer: PCT/EP2005/000402
(87) Internationale Veröffentlichungsnummer: WO 2005/074012

(56) Entgegenhaltungen:
- US-A- 5 786 609
- NEESER W ET AL: "DEPFET-a pixel device with integrated amplification" NUCLEAR INSTRUMENTS & METHODS IN PHYSICS RESEARCH, SECTION - A: ACCELERATORS, SPECTROMETERS, DETECTORS AND ASSOCIATED EQUIPMENT, NORTH-HOLLAND PUBLISHING COMPANY. AMSTERDAM, NL, Bd. 477, Nr. 1-3, 21. Januar 2002 (2002-01-21), Seiten 129-136, XP004345526 ISSN: 0168-9002
- FISCHER P ET AL: "First operation of a pixel imaging matrix based on DEPFET pixels" NUCLEAR INSTRUMENTS & METHODS IN PHYSICS RESEARCH, SECTION - A: ACCELERATORS, SPECTROMETERS, DETECTORS AND ASSOCIATED EQUIPMENT, NORTH-HOLLAND PUBLISHING COMPANY. AMSTERDAM, NL, Bd. 451, Nr. 3, 11. September 2000 (2000-09-11), Seiten 651-656, XP004208738 ISSN: 0168-9002
- ULRICI J ET AL: "Spectroscopic and imaging performance of DEPFET pixel sensors" NUCLEAR INSTRUMENTS & METHODS IN PHYSICS RESEARCH, SECTION - A: ACCELERATORS, SPECTROMETERS, DETECTORS AND ASSOCIATED EQUIPMENT, NORTH-HOLLAND PUBLISHING COMPANY. AMSTERDAM, NL, Bd. 465, Nr. 1, 1. Juni 2001 (2001-06-01), Seiten 247-252, XP004246811 ISSN: 0168-9002

## Beschreibung

Die Erfindung betrifft eine Halbleiterstruktur, insbesondere in einem Halbleiterdetektor, gemäß dem Oberbegriff des Anspruchs 1.

Es ist bekannt, zur Strahlungsdetektion sogenannte Driftdetektoren einzusetzen, die beispielsweise in L. STRÜDER: "Nuclear Instruments and Methods in Physics Research A", Bd. 454, 2000, DE 34 27 476 A1 sowie in DE 102 13 812 A1 beschrieben sind. Hierbei erzeugt die zu detektierende Strahlung in einem schwach dotierten, verarmten Halbleitersubstrat Signalelektronen, wobei an einer Oberfläche des Halbleitersubstrats mehrere ringförmige und konzentrisch angeordnete Elektroden angeordnet sind, die in dem Halbleitersubstrat ein Driftfeld erzeugen, durch das die von der Strahlung erzeugten Signalelektronen zu einem mittig angeordneten Ausleseelement driften, das die Signalelektronen und damit die aufgenommene Strahlung detektiert.

Das Ausleseelement kann hierbei aus einem DEPFET-Transistor (DEPFET - Depleted Field Effect Transistor) bestehen, der im Jahre 1984 von J. Kemmer und G. Lutz erfunden wurde. Ein derartiger DEPFET-Transistor kann ein schwach n-dotiertes, verarmtes Halbleitersubstrat aufweisen, wobei an einer Oberfläche des Halbleitersubstrats eine stark p-dotierte Rückelektrode angeordnet ist, die mit dem schwach n-dotierten Halbleitersubstrat eine in Sperrrichtung gepolte Diode bildet und zur Verarmung des Halbleitersubstrats dient, wobei in dem Halbleitersubstrat durch Strahlungseinwirkung entstandene Löcher über die Rückelektrode aus dem Halbleitersubstrat abgesaugt werden.

An der gegenüberliegenden Oberfläche des Halbleitersubstrats befindet sich bei einem DEPFET-Transistor ein stark p-dotiertes Source-Gebiet und ein ebenfalls stark p-dotiertes Drain-Gebiet, wobei sich zwischen dem Source-Gebiet und dem Drain-Gebiet ein Leitungskanal befindet, dessen Leitfähigkeit durch eine extern ansteuerbare Gate-Elektrode eingestellt werden kann.

In dem Halbleitersubstrat befindet sich unter dem Leitungskanal ein schwach n-dotiertes inneres Gate-Gebiet, in dem sich die in dem Halbleitersubstrat durch Strahlungseinwirkung entstandenen Signalelektronen sammeln. Die in dem inneren Gate-Gebiet angesammelte elektrische Ladung steuert die Leitfähigkeit des Leitungskanals zwischen dem Source-Gebiet und dem Drain-Gebiet in ähnlicher Weise wie die externe Gate-Elektrode, so dass der Drain-Source-Strom ein Maß für die detektierte Strahlung ist.

Die in dem inneren Gate-Gebiet angesammelten Signalelektronen müssen jedoch gelegentlich aus dem inneren Gate-Gebiet entfernt werden, um die Empfindlichkeit des Driftdetektors zu erhalten. Hierzu ist bei den bekannten DEPFET-Transistoren ein separater Löschkontakt vorgesehen, der source-seitig neben dem eigentlichen DEPFET-Transistor angeordnet ist und durch Anlegen einer positiven elektrischen Spannung die in dem inneren Gate-Gebiet angesammelten Signalelektronen absaugt.

Nachteilig an diesem bekannten Aufbau eines DEPFET-Transistors ist die Tatsache, dass zum Löschen hohe elektrische Spannungen erforderlich sind, wobei eine vollständige Entfernung der in dem inneren Gate-Gebiet angesammelten Signalelektronen oftmals überhaupt nicht möglich ist.

Das Dokument von W. Neeser et. al., Nuclear Instruments and Methods in Physics Research, section A : Accelerators, Spectrometers, Detectors and Associated Equipment, North-Holland Publishing Company, Amsterdam, NL, Bd. 477, Nr. 1-3, 21.01.2002, p. 129-136, beschreibt eine Vorrichtung mit integrierter Verstärkung.

Das Dokument von W. Neeser et. al., Nuclear Instruments and Methods in Physics Research, section A : Accelerators, Spectrometers, Detectors and Associated Equipment, North-Holland Publishing Company, Amsterdam, NL, Bd. 477, Nr. 1-3, 21.01.2002, p. 129-136, beschreibt eine Vorrichtung mit integrierter Verstärkung.

Der Erfindung liegt deshalb die Aufgabe zugrunde, eine Halbleiterstruktur entsprechend einem DEPFET-Transistor zu schaffen, bei der mit geringeren elektrischen Spannungen eine möglichst vollständige Löschung möglich ist.

Diese Aufgabe wird, ausgehend von der vorstehend beschriebenen bekannten DEPFET-Struktur gemäß dem Oberbegriff des Anspruchs 1, durch die kennzeichnenden Merkmale des Anspruchs 1 gelöst.

Die Erfindung beruht auf der Erkenntnis, dass das Source-Gebiet der DEPFET-Struktur in dem Halbleitersubstrat eine Potentialbarriere erzeugt, die das Absaugen der in dem internen Gate-Gebiet angesammelten Signalelektronen durch den Löschkontakt erschwert, so dass bei den bekannten DEPFET-Transistoren eine hohe Löschspannung erforderlich ist, damit die Signalelektronen die Potentialbarriere überwinden können.

Die Erfindung umfasst deshalb die technische Lehre, dass sich das innere Gate-Gebiet der Halbleiterstruktur in dem Halbleiter-Substrat mindestens teilweise bis zu dem Löschkontakt erstreckt, um das Absaugen der Ladungsträger aus dem inneren Gate-Gebiet zu erleichtern.

Darüber hinaus umfasst die Erfindung die technische Lehre, den Löschkontakt nicht mehr source-seitig neben der DEPFET-Struktur anzuordnen, sondern drain-seitig, so dass die in dem internen Gate-Gebiet angesammelten Signalelektronen beim Absaugen durch den Löschkontakt nicht mehr die von dem Source-Gebiet erzeugte Potentialbarriere überwinden müssen.

In einer Variante der Erfindung ist der Löschkontakt in dem Halbleitersubstrat mindestens teilweise zwischen dem Source-Gebiet und dem Drain-Gebiet angeordnet, was insbesondere bei einer ringförmig geschlossenen DEPFET-Struktur vorteilhaft ist.

Es ist jedoch alternativ auch möglich, dass der Löschkontakt auf der dem Source-Gebiet abgewandten Seite des Gate-Gebiets angeordnet ist, was insbesondere bei einer linearen DEPFET-Struktur vorteilhaft sein kann.

Darüber hinaus umfasst die erfindungsgemäße Halbleiterstruktur vorzugsweise ein sogenanntes Drain-Lösch-Gebiet, das wahlweise als Hilfslöschkontakt oder als Drain ansteuerbar ist, wobei das Drain-Lösch-Gebiet vorzugsweise an den Löschkontakt und an das Drain-Gebiet angrenzt. Während des Löschvorgangs erzeugt das als Hilfslöschkontakt angesteuerte Drain-Lösch-Gebiet keine durch Drain-Implantation oder Begrenzung der vergrabenen Dotierung des inneren Gate-Gebiets hervorgerufene Potentialbarriere, die von den im inneren Gate-Gebiet angesammelten Ladungsträgern beim Löschen überwunden werden müsste, so dass zum Löschen relativ geringe elektrische Spannungen an dem Löschkontakt ausreichen. Falls das Halbleitersubstrat schwach n-dotiert ist und das Source-Gebiet und das Drain-Gebiet stark p-dotiert sind, so wirkt das Drain-Lösch-Gebiet bei einer ausreichend negativen elektrischen Spannung an dem Drain-Lösch-Gebiet als Drain, wohingegen das Drain-Lösch-Gebiet bei ausreichend positiven Spannungen eine Löschung der in dem inneren Gate-Gebiet gespeicherten Ladungsträger durch den Löschkontakt ermöglicht.

Bei einer Vertauschung des Source-Gebiets und des Drain-Gebiets kann anstelle des Drain-Lösch-Gebiets auch entsprechend ein Source-Lösch-Gebiet vorgesehen sein, das wahlweise als Hilfslöschkontakt oder als Source ansteuerbar ist, wobei das Source-Lösch-Gebiet vorzugsweise an den Löschkontakt und an das Source-Gebiet angrenzt. Die Funktion des Source-Lösch-Gebiets ist jedoch im Wesentlichen dieselbe wie die Funktion des vorstehend beschriebenen Drain-Lösch-Gebiets.

In diesem Zusammenhang ist zu erwähnen, dass die erfindungsgemäße Halbleiterstruktur auch umgekehrt dotiert sein kann. Im Rahmen dieser Beschreibung wird deshalb allgemein von einem ersten Dotierungstyp und einem zweiten Dotierungstyp gesprochen. Bei dem ersten Dotierungstyp für das Halbleitersubstrat, das innere Gate-Gebiet und den Löschkontakt handelt es sich vorzugsweise um eine N-Dotierung, während der zweite Dotierungstyp für die Rückelektrode, das Source-Gebiet, das Drain-Gebiet, das Abschirm-Gebiet unterhalb des Löschkontakts sowie das vorzugsweise großflächige Abschirm-Gebiet unterhalb des Source-Gebiets vorzugsweise eine P-Dotierung ist.

Es ist jedoch umgekehrt auch möglich, dass es sich bei dem ersten Dotierungstyp für das Halbleitersubstrat, das innere Gate-Gebiet und den Löschkontakt um eine P-Dotierung handelt, während der zweite Dotierungstyp für das Source-Gebiet, das Drain-Gebiet, die Rückelektrode und die Abschirm-Gebiete durch eine N-Dotierung gebildet wird.

In einer Variante der Erfindung ist in dem Halbleitersubstrat unterhalb des inneren Gate-Gebiets unter dem Löschkontakt ein dotiertes Abschirm-Gebiet des zweiten Dotierungstyps angeordnet, um den Löschkontakt elektrisch abzuschirmen. Bei einem n-dotierten inneren Gate-Gebiet und einem schwach n-dotierten Halbleitersubstrat ist dieses Abschirm-Gebiet entsprechend p-dotiert. Das Abschirm-Gebiet unterhalb des Löschkontakts und des inneren Gate-Gebiets verhindert, dass in dem Halbleitersubstrat durch Strahlungseinwirkung entstandene Signalelektronen direkt zu dem Löschkontakt abfließen, anstatt sich in dem inneren Gate-Gebiet zu sammeln.

In einer Variante der Erfindung erstreckt sich das innere Gate-Gebiet in dem Halbleitersubstrat von dem Source-Gebiet bis zu dem Drain-Gebiet und ist vorzugsweise sogar vollständig durchgehend. Hierbei ist jedoch zu berücksichtigen, dass sich die Signalelektronen in dem inneren Gate vorzugsweise unterhalb des Leitungskanals des DEPFET-Transistors und nicht unter dessen Source-Gebiet sammeln sollten, um die Leitfähigkeit des Leitungskanals steuern zu können. Die Dotierung des Source-Gebiets ist deshalb vorzugsweise so eingestellt, dass diese teilweise vertikal bis in das innere Gate-Gebiet hineinreicht und dort die Dotierung des inneren Gate-Gebiets kompensiert, was zu einer Potentialbarriere für die in dem inneren Gate-Gebiet angesammelten Signalelektronen führt. Durch diese Potentialbarriere werden die in dem inneren Gate-Gebiet angesammelten Signalelektronen von dem Source-Gebiet verdrängt und unterhalb des Leitungskanals der DEPFET-Struktur konzentriert, wodurch die Steuerwirkung der angesammelten Signalelektronen verbessert wird.

Es ist jedoch alternativ auch möglich, dass das innere Gate-Gebiet in dem Halbleitersubstrat zu dem Source-Gebiet beabstandet ist, so dass die in dem inneren Gate-Gebiet angesammelten Signalelektronen nicht bis unter das Source-Gebiet gelangen können, sondern unterhalb des Leitungskanals der DEPFET-Struktur konzentriert und in Richtung der Drain verschoben werden, wo sie die Leitfähigkeit des Leitungskanals effektiv steuern.

Wenn sich das innere Gate-Gebiet in dem Halbleitersubstrat nicht bis unter das Source-Gebiet erstreckt, ist jedoch zu beachten, dass Löcher von dem Source-Gebiet in das Halbleiter-Substrat emittiert werden können und dann zu einer auf der gegenüberliegenden Seite des Halbleitersubstrats angeordneten Rückelektrode abfließen. Dies kann jedoch im Rahmen der Erfindung durch ein zusätzliches Abschirm-Gebiet verhindert werden, das in dem Halbleitersubstrat unterhalb des inneren Gate-Gebiets angeordnet ist und sich beispielsweise über die gesamte Fläche des Halbleitersubstrats erstrecken kann. Dieses zusätzliche Abschirm-Gebiet ist entsprechend dem ersten Dotierungstyp dotiert. Dies bedeutet, dass das zusätzliche Abschirm-Gebiet zur Abschirmung des Source-Gebiets und zur Verhinderung einer Löcheremission bei einem schwach n-dotierten Halbleitersubstrat ebenfalls n-dotiert ist.

Bei einer Variante der Erfindung grenzt der Leitungskanal der DEPFET-Struktur unmittelbar an den Löschkontakt an.

Es ist jedoch alternativ auch möglich, dass der Leitungskanal nur bis auf einen vorgegebenen Abstand an den Löschkontakt herangeführt ist. Ein derartiger Abstand zwischen dem Leitungskanal und dem Löschkontakt verringert vorteilhaft die elektrische Feldstärke am Rand des Löschkontakts. Aus dem gleichen Grund kann auch das Drain-Lösch-Gebiet leicht vom Löschkontakt zurückgezogen sein.

Der im Rahmen der Erfindung verwendete Begriff eines Leitungskanals kann funktional oder strukturell definiert werden, wie im folgenden kurz ausgeführt wird.

So ist der Leitungskanal beispielsweise bei sogenannten Enhancement-Transistoren nicht besonders dotiert und unterscheidet sich deshalb nicht von dem umgebenden Halbleitersubstrat, so dass der Leitungskanal erst durch die externe Ansteuerung durch das sogenannte Gate entsteht. In diesem Fall ist der Leitungskanal der stromführende Bereich des Halbleitersubstrats zwischen Drain und Source.

Bei anderen Transistortypen, wie beispielsweise einem JFET, ist der Leitungskanal dagegen besonders dotiert und lässt sich deshalb unabhängig von der Funktion der Stromleitung räumlich eingrenzen.

Weiterhin ist zu erwähnen, dass das Drain-Gebiet bei der erfindungsgemäßen DEPFET-Struktur in mehrere zueinander beabstandete Teilgebiete aufgeteilt sein kann. Ein Teilgebiet des Drain-Gebiets kann dann beispielsweise direkt kontaktiert werden, während das andere Teilgebiet des Drain-Gebiets über eine Inversionsschicht unterhalb des Drain-Lösch-Gebiets kontaktiert werden kann.

Hierbei kann zur Kontaktierung des Drain-Gebietes oder von dessen Teilgebieten eine Leitungsüberführung eingesetzt werden, die beispielsweise in DE 102 13 812 A1 beschrieben ist, so dass der Inhalt dieser Druckschrift hinsichtlich der Gestaltung einer Leitungsüberführung der vorliegenden Beschreibung in vollem Umfang zuzurechnen ist.

Es wurde bereits vorstehend kurz erwähnt, dass die erfindungsgemäße DEPFET-Struktur ringförmig ausgebildet sein kann und entsprechend ein ringförmiges Gate-Gebiet aufweist.

Bei einem derartigen ringförmigen Aufbau der DEPFET-Struktur können der Löschkontakt und/oder das Drain-Gebiet und/oder das Drain-Lösch-Gebiet innerhalb des ringförmigen Gate-Gebiets angeordnet sein, während das Source-Gebiet außerhalb des ringförmigen Gate-Gebiets angeordnet ist.

Es ist jedoch alternativ auch möglich, dass der Löschkontakt und/oder das Drain-Gebiet und/oder das Drain-Lösch-Gebiet außerhalb des ringförmigen Gate-Gebiets angeordnet sind, während das Source-Gebiet innerhalb des ringförmigen Gate-Gebiets angeordnet ist.

Weiterhin kann das Drain-Lösch-Gebiet an den gesamten Umfang des ringförmigen Gate-Gebiets anschließen. Es ist jedoch alternativ auch möglich, dass das ringförmige Gate-Gebiet nur mit einem Teil des Umfangs an das Drain-Lösch-Gebiet und mit dem Rest des Umfangs an ein dotiertes Gebiet des zweiten Dotierungstyps (in der Regel p-dotiert) angrenzt, das mit dem Drain-Gebiet verbunden ist und/oder an das Drain-Gebiet angrenzt.

Weiterhin kann der Löschkontakt in mehrere zueinander beabstandete Teile aufgeteilt sein oder es können mehrere Löschkontakte vorgesehen sein, die voneinander getrennt sind. Dies bietet den Vorteil, dass der mittlere Abstand zwischen den abzusaugenden Signalelektronen und dem nächstgelegenen Löschkontakt verringert wird, was bei einer vorgegebenen Diffusionsgeschwindigkeit der Signalelektronen zu einer Verkürzung des Löschvorgangs führt, was im Ergebnis ein schnelleres Löschen ermöglicht.

Ferner ist zu erwähnen, dass der Löschkontakt bei der erfindungsgemäßen Halbleiterstruktur mit einer dotierten Schicht des zweiten Dotierungstyps (in der Regel p-dotiert) unterlegt sein kann.

Ferner ist zu erwähnen, dass als Halbleitermaterial vorzugsweise Silizium verwendet wird. Die Erfindung ist jedoch hinsichtlich des zu verwendenden Halbleitermaterials nicht auf Silizium beschränkt, sondern auch mit anderen Halbleitermaterialien realisierbar. Darüber hinaus sind auch andere Isolator- und Leiter-Materialien bei der erfindungsgemäßen Halbleiterstruktur verwendbar.

Es versteht sich hierbei von selbst, dass das vorstehend erwähnte Drain-Lösch-Gebiet vorzugsweise ein MOS-Gebiet ist.

Darüber hinaus ist für den Fachmann klar, dass die erfindungsgemäße Halbleiterstruktur dem Verarmungstyp angehören kann, wobei eine zusätzliche Kanalimplantation vorgesehen ist.

Es ist jedoch alternativ auch möglich, dass die erfindungsgemäße Halbleiterstruktur dem Anreicherungstyp angehört, wobei keine zusätzliche Kanalimplantation erfolgen muss.

Ferner kann das vorstehend erwähnte Drain-Lösch-Gebiet oder das Source-Lösch-Gebiet mit einer oberflächennahen Implantation des zweiten Dotierungstyps unterlegt sein. Diese zusätzliche oberflächennahe Dotierung bewirkt eine Verschiebung der für den Betrieb der Struktur nötigen Spannungen an dem Source-Lösch-Gebiet bzw. dem Drain-Lösch-Gebiet. Man kann diese damit in einen günstigeren Bereich bringen. Dies ist insbesondere bei Anreicherungstypen nötig, da sonst die bei Silizium auftretenden positiven Ladungen im Strom-führenden Zustand eine hohe negative Spannung am SCG bzw. DCG erfordern. Natürlich ist es auch möglich, für die Gate-Region eine analoge Maßnahme zu treffen.

Schließlich umfasst die Erfindung nicht nur die vorstehend beschriebene DEPFET-Struktur, sondern betrifft auch einen vollständigen Detektor, bei dem die erfindungsgemäße DEPFET-Struktur als Ausleseelement des Detektors eingesetzt ist. Zur Vermeidung von Wiederholungen wird hinsichtlich des Aufbaues eines derartigen Halbleiterdetektors auf die bereits vorstehend zitierte Druckschrift DE 102 13 812 A1 verwiesen, deren Inhalt der vorliegenden Beschreibung hinsichtlich des Aufbaus eines Halbleiterdetektors in vollem Umfang zu rechnen ist.

Andere vorteilhafte Weiterbildungen der Erfindung sind in den Unteransprüchen gekennzeichnet oder werden nachstehend zusammen mit der Beschreibung der bevorzugten Ausführungsbeispiele der Erfindung anhand der Figuren näher erläutert. Es zeigen:
- Fig. 1a: eine Querschnittsansicht einer linearen erfindungsgemäßen DEPFET-Struktur entlang der Schnittlinie A-A in Fig. 1b,
- Fig. 1b: eine Aufsichtsdarstellung der DEPFET-Struktur aus Fig. 1a,
- Fig. 1c: eine Querschnittsansicht der DEPFET-Struktur aus den Figuren 1a und 1b entlang der Schnittlinie B-B in Fig. 1b
- Fig. 2: ein weiteres Ausführungsbeispiel einer erfindungsgemäßen linearen DEPFET-Struktur in einer Aufsichtsdarstellung,
- Fig. 3a: eine Aufsichtsdarstellung einer erfindungsgemäßen ringförmigen DEPFET-Struktur,
- Fig. 3b: eine Querschnittsansicht der DEPFET-Struktur aus Fig. 3a entlang der Schnittlinie A-A in Fig. 3a,
- Fig. 4a: ein weiteres Ausführungsbeispiel einer erfindungsgemäßen ringförmigen DEPFET-Struktur in einer Aufsichtsdarstellung,
- Fig. 4b: eine Querschnittsansicht der DEPFET-Struktur aus Fig. 4a entlang der Schnittlinie A-A in Fig. 4a,
- Fig. 5a: ein anderes Ausführungsbeispiel einer erfindungsgemäßen ringförmigen DEPFET-Struktur in einer Aufsichtsdarstellung,
- Fig. 5b: eine Querschnittsansicht der DEPFET-Struktur aus Fig. 5a entlang der Schnittlinie A-A in Fig. 5a,
- Fig. 6a: einen Driftdetektor mit einer erfindungsgemäßen DEPFET-Struktur als Ausleseelement in einer Aufsichtsdarstellung,
- Fig. 6b: eine Querschnittsansicht durch den Driftdetektor gemäß Fig. 6a entlang der Schnittlinie A-A in Fig. 6a,
- Fig. 7a: ein anderes Ausführungsbeispiel eines Driftdetektors mit einer erfindungsgemäßen DEPFET-Struktur als Ausleseelement in einer Aufsichtsdarstellung,
- Fig. 7b: eine Querschnittsansicht des Driftdetektors aus Fig. 7a entlang der Schnittlinie A-A in Fig. 7a.
- Fig. 8a: ein weiteres Ausführungsbeispiel eines Driftdetektors mit einer erfindungsgemäßen DEPFET-Struktur als Ausleseelement in einer Aufsichtsdarstellung, wobei ein Source-Lösch-Gebiet mit einer oberflächennahen Dotierung unterlegt ist,
- Fig. 8b: eine Querschnittsansicht des Driftdetektors aus Fig. 8a entlang der Schnittlinie A-A in Fig. 8a,
- Fig. 9a: ein anderes Ausführungsbeispiel eines Driftdetektors mit einer erfindungsgemäßen DEPFET-Struktur als Ausleseelement in einer Aufsichtsdarstellung, wobei ein Drain-Lösch-Gebiet mit einer oberflächennahen Dotierung unterlegt ist sowie
- Fig. 9b: eine Querschnittsansicht des Driftdetektors aus Fig. 9a entlang der Schnittlinie A-A in Fig. 9a.

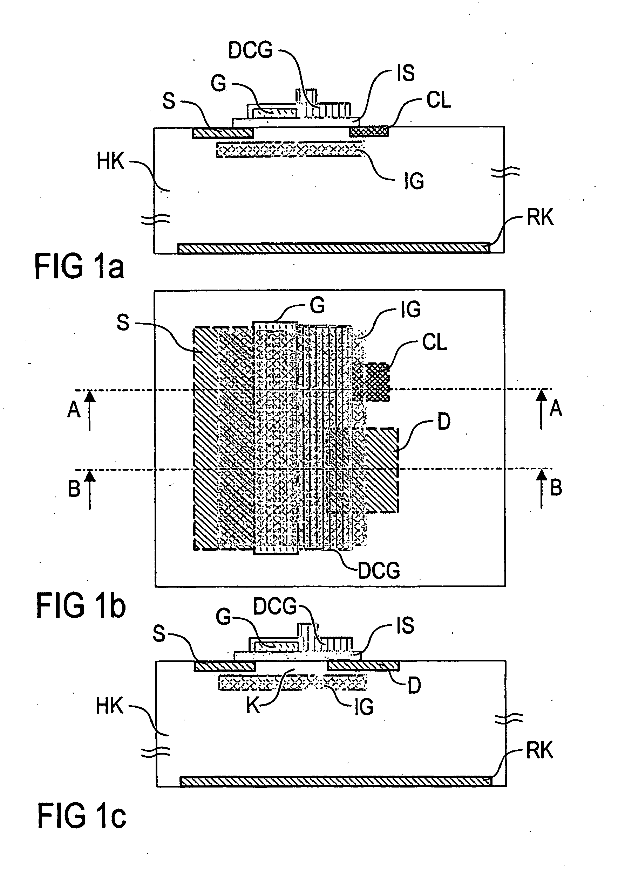

Die in den Figuren 1a-1c dargestellte DEPFET-Struktur kann als Ausleseelement in einem Driftdetektor eingesetzt werden, der in L. STRÜDER: "Nuclear Instruments and Methods in Physics Research A", Bd. 454, 2000 sowie in DE 34 27 476 A1 beschrieben ist, so dass der Inhalt dieser Veröffentlichungen der folgenden Beschreibung in vollem Umfang zuzurechnen ist.

Die erfindungsgemäße DEPFET-Struktur weist einen schwach n-dotierten plattenförmigen Halbleiterkörper HK auf, der beispielsweise eine Dicke von 300 µm aufweisen kann.

Auf der in der Zeichnung unten liegenden Rückseite des Halbleiterkörpers HK ist eine flächige Elektrode RK angeordnet, die aus einem stark p-dotierten Gebiet besteht, wobei die Elektrode RK mit dem Halbleiterkörper HK eine in Sperrrichtung gepolte Diode bildet und zur Verarmung des Halbleiterkörpers HK dient. Im Betrieb der DEPFET-Struktur wird deshalb ein positives elektrisches Potential an die Elektrode RK angelegt, um die Signalelektronen aus dem Halbleiterkörper HK abzusaugen und den Halbleiterkörper HK dadurch zu verarmen.

An der gegenüberliegenden Oberfläche des Halbleiterkörpers HK befindet sich eine Transistorstruktur mit einem stark p-dotierten Source-Gebiet S und einem ebenfalls stark p-dotierten Drain-Gebiet D, wobei sich zwischen dem Source-Gebiet S und dem Drain-Gebiet D ein Leitungskanal K befindet, dessen Leitfähigkeit durch ein Gate-Gebiet G gesteuert werden kann, indem ein entsprechendes elektrisches Potential an das Gate-Gebiet G angelegt wird.

Darüber hinaus befindet sich in dem Halbleiterkörper HK unterhalb des Leitungskanals K ein vergrabenes, n-dotiertes inneres Gate-Gebiet IG, in dem sich Signalelektronen sammeln, die aufgrund einer zu detektierenden Strahlungswirkung in dem Halbleiterkörper HK entstehen. Die in dem inneren Gate-Gebiet IG angesammelten Signalelektronen steuern die Leitfähigkeit des Leitungskanals K in ähnlicher Weise wie ein an das Gate-Gebiet G angelegtes elektrisches Steuersignal, so dass die Leitfähigkeit des Leistungskanals K ein Maß für die in dem inneren Gate-Gebiet IG angesammelten Ladungsträger und damit für die eingefallene Strahlung ist.

Das innere Gate-Gebiet IG weist jedoch nur eine begrenzte Aufnahmefähigkeit für die durch Strahlungseinwirkung entstandenen Signalelektronen auf und muss deshalb gelegentlich wieder geleert werden, um die Empfindlichkeit der gesamten DEPFET-Struktur aufrecht zu erhalten. Hierzu ist ein Löschkontakt CL vorgesehen, der aus einem stark n-dotierten Gebiet an der Oberfläche der Halbleiterkörpers HK besteht, wobei der Löschkontakt CL auf der dem Source-Gebiet S gegenüberliegenden Seite des Gate-Gebiets neben dem Drain-Gebiet angeordnet ist.

Das innere Gate-Gebiet IG erstreckt sich hierbei in seitlicher Richtung bis unter den Löschkontakt CL. Dies bietet den Vorteil, dass das Absaugen der Signalelektronen aus dem inneren Gate-Gebiet IG nicht durch die Potentialbarriere behindert wird, die durch die in das innere Gate-Gebiet IG hineinreichende starke P-Dotierung des Source-Gebietes S erzeugt wird. Die in dem inneren Gate-Gebiet IG angesammelten Signalelektronen können deshalb mit einer relativ kleinen positiven Löschspannung abgesaugt werden, die an den Löschkontakt CL angelegt wird.

Die bereits vorstehend erwähnte starke P-Dotierung des Source-Gebiets wirkt bis in das innere Gate-Gebiet IG hinein und hat zur Folge, dass die in dem inneren Gate-Gebiet IG angesammelten Signalelektronen unterhalb des Leitungskanals K und nicht unterhalb des Source-Gebiets konzentriert werden. Dies ist sinnvoll, da die unterhalb des Source-Gebiets S in dem inneren Gate-Gebiet IG befindlichen Signalelektronen nicht zur Steuerung der Leitfähigkeit des Leitungskanals K beitragen.

Eine entsprechende drain-seitige Beeinflussung des inneren Gate-Gebietes IG durch die starke Dotierung des Drain-Gebiets D ist nicht erforderlich, da die an dem Drain-Gebiet D anliegende negative Spannung die in dem inneren Gate-Gebiet IG befindlichen Signalelektronen ohnehin unterhalb des Leitungskanals K konzentriert.

Aus diesem Grund ist es auch möglich, das Drain-Gebiet D durch eine Inversionsschicht IS getrennt unter einem Drain-Lösch-Gebiet DCG auszubilden, wobei das Drain-Lösch-Gebiet DCG direkt an das p-dotierte Drain-Gebiet D und den n-dotierten Löschkontakt CL anschließt.

Das Drain-Lösch-Gebiet DCG kann in Abhängigkeit von seiner elektrischen Ansteuerung wahlweise die Löschung des inneren Gate-Gebiets IG unterstützen oder als zusätzliches Drain-Gebiet dienen. Bei genügend negativer Spannung an dem Drain-Lösch-Gebiet DCG übernimmt das Drain-Lösch-Gebiet DCG die Funktion der Drain, während es bei genügend positiven Spannungen an dem Drain-Lösch-Gebiet DCG und am Löschkontakt CL das Löschen der in dem inneren Gate-Gebiet IG gespeicherten Signalelektronen ermöglicht. Da die tiefe N-Dotierung hierbei bis zum Löschkontakt CL unbeeinflusst bleibt, ist dabei keine Potentialbarriere zu überwinden, so dass das vollständige Löschen mit relativ geringen Spannungen am Löschkontakt CL erfolgen kann. Darüber hinaus hat das Drain-Lösch-Gebiet DCG noch eine weitere Funktion am Ende des Löschvorgangs. So kann der Übergang zum Auslese- oder Speichermodus, bei dem das Drain-Lösch-Gebiet DCG wieder die Funktion des Drains übernimmt, hierbei vor dem Rücksetzen des Löschkontakts CL erfolgen. Bei dieser Abfolge wird vorteilhaft verhindert, dass Elektronen aus dem Löschkontakt CL in das innere Gate-Gebiet IG fließen.

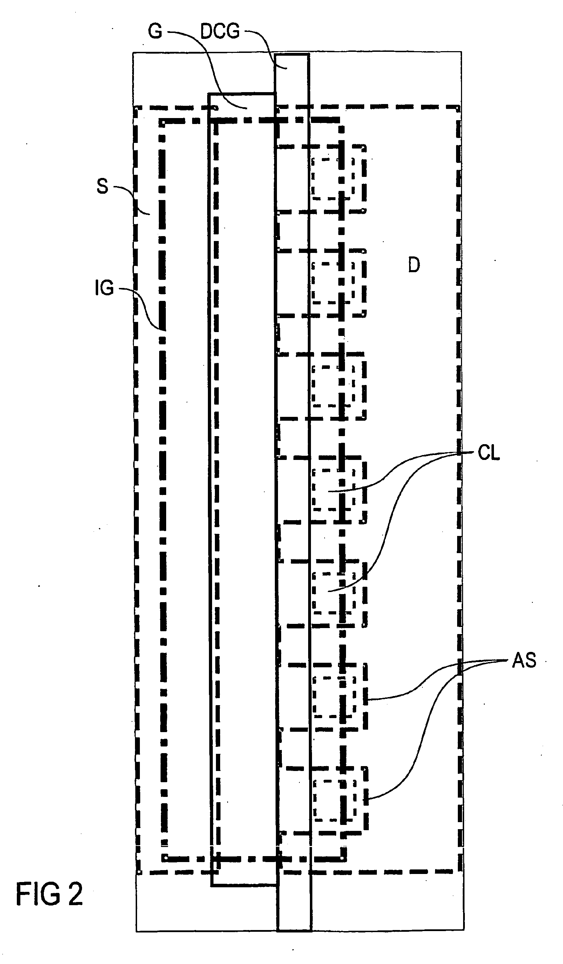

Figur 2 zeigt eine Aufsichtsdarstellung eines alternativen Ausführungsbeispiels einer linearen DEPFET-Struktur, wobei dieses Ausführungsbeispiel weitgehend mit dem vorstehend beschriebenen und in den Figuren 1a-1c dargestellten Ausführungsbeispiel übereinstimmt. Zur Vermeidung von Wiederholungen wird deshalb weitgehend auf die vorstehende Beschreibung verwiesen, wobei für entsprechende Bauteile dieselben Bezugszeichen verwendet werden.

Eine Besonderheit dieses Ausführungsbeispiels besteht darin, dass sich das Drain-Gebiet D im Wesentlichen über die gesamte Ausdehnung der DEPFET-Struktur erstreckt, wobei das Drain-Gebiet D jeweils gate-seitig Aussparungen AS für mehrere Löschkontakte CL aufweist. Die räumlich verteilte Anordnung mehrerer Löschkontakte CL bietet den Vorteil, dass der mittlere Abstand zwischen den abzusaugenden Signalelektronen in dem inneren Gate-Gebiet IG und dem nächstliegenden Löschkontakt CL verringert wird, so dass eine kürzere Löschdauer ausreicht.

Die einzelnen Löschkontakte CL sind hierbei elektrisch miteinander verbunden und werden gemeinsam angesteuert, wobei die Verbindung der Löschkontakte CL zur Vereinfachung nicht dargestellt ist.

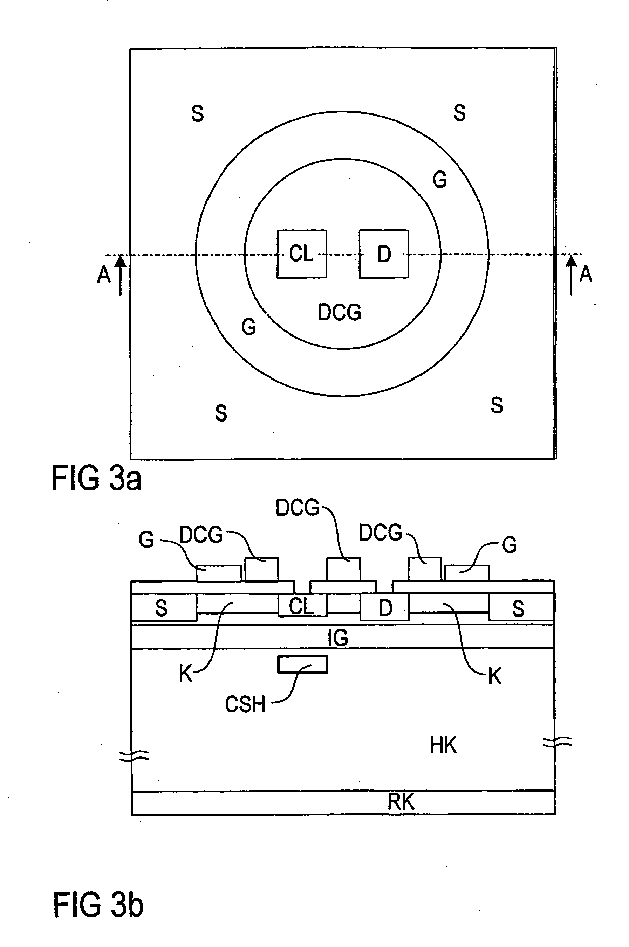

Die Figuren 3a und 3b zeigen ein Ausführungsbeispiel einer erfindungsgemäßen ringförmigen DEPFET-Struktur, die beispielsweise in dem in L. STRÜDER: "Nuclear Instruments and Methods in Physics Research A", Bd. 454, 2000, DE 102 13 812 A1 oder DE 34 27 476 A1 beschriebenen Driftdetektor als Ausleseelement eingesetzt werden kann.

Auch dieses Ausführungsbeispiel stimmt teilweise mit dem vorstehend beschriebenen und in den Figuren 1a-1c dargestellten Ausführungsbeispielen einer linearen DEPFET-Struktur überein, so dass zur Vermeidung von Wiederholungen weitgehend auf die vorstehende Beschreibung zu den Figuren 1a-1c verwiesen wird und im Folgenden für entsprechende Bauteile dieselben Bezugszeichen verwendet werden.

Eine Besonderheit dieses Ausführungsbeispiels besteht darin, dass sich das innere Gate-Gebiet IG über die gesamte Fläche erstreckt. Die starke P-Dotierung des Source-Gebiets S wirkt hierbei unter dem Source-Gebiet S bis in das innere Gate-Gebiet IG hinein, wodurch die in dem inneren Gate-Gebiet IG angesammelten Signalelektronen in Richtung des Drain-Gebiets D verdrängt werden. Dies ist sinnvoll, da nur die in dem inneren Gate-Gebiet IG unterhalb des Leitungskanals K befindlichen Signalelektronen die Leitfähigkeit des Leitungskanals K beeinflussen und dadurch in die Messung eingehen, wohingegen unterhalb des Source-Gebiets S befindliche Signalelektronen keinen Einfluss auf die Leitfähigkeit des Leitungskanals K haben.

Eine weitere Besonderheit dieses Ausführungsbeispiels besteht darin, dass sich in dem Halbleiterkörper HK unterhalb des inneren Gate-Gebiets IG im Bereich des Löschkontakts CL ein p-dotiertes Abschirm-Gebiet CSH befindet, das verhindern soll, dass Signalelektronen aus dem Halbleiterkörper HK direkt zu dem Löschkontakt CL abfließen.

Der Löschkontakt CL befindet sich hierbei innerhalb des ringförmigen Gate-Gebietes neben dem Drain-Gebiet D.

Darüber hinaus weist die DEPFET-Struktur in diesem Ausführungsbeispiel ein Drain-Lösch-Gebiet DCG aus einer MOS-Struktur auf, wobei das Drain-Lösch-Gebiet DCG unmittelbar an den Löschkontakt CL und an das Drain-Gebiet D angrenzt.

Auch bei diesem Ausführungsbeispiel ermöglicht die drain-seitige Anordnung des Löschkontakts CL eine Löschung der in dem inneren Gate-Gebiet IG angesammelten Signalelektronen mit einer relativ geringen Löschspannung, da die Signalelektronen beim Absaugen die von dem Source-Gebiet S und/oder dem Drain-Gebiet D erzeugte Potentialbarriere nicht überwinden müssen.

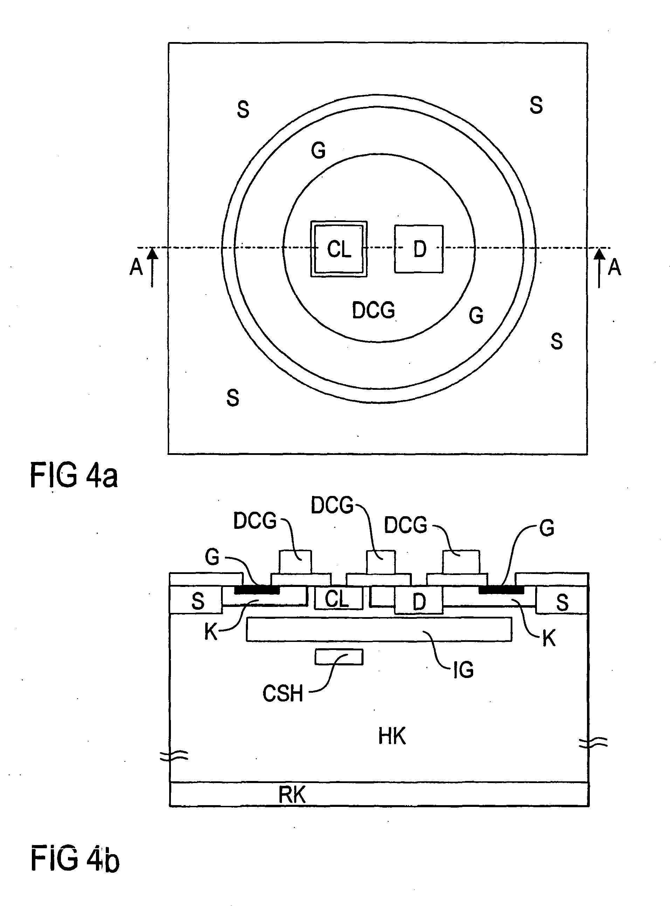

Die Figuren 4a und 4b zeigen ein weiteres Ausführungsbeispiel einer erfindungsgemäßen ringförmigen DEPFET-Sruktur, das weitgehend mit dem vorstehend beschriebenen und in den Figuren 3a und 3b beschriebenen Ausführungsbeispiel übereinstimmt, so dass zur Vermeidung von Wiederholungen weitgehend auf die vorstehende Beschreibung verwiesen wird und im Folgenden für entsprechende Bauteile dieselben Bezugszeichen verwendet werden.

Eine Besonderheit dieses Ausführungsbeispiels besteht in der Gestaltung des Gate-Gebiets G, das als flaches n-dotiertes Gebiet ausgebildet ist.

Eine weitere Besonderheit dieses Ausführungsbeispiels besteht darin, dass der Leitungskanal K nicht direkt bis an den Löschkontakt CL herangeführt ist, sondern von diesem einen vorgegebenen Abstand einhält. Damit wird die elektrische Feldstärke am Rand des Löschkontakts CL verringert. Aus dem gleichen Grund ist hier auch das Drain-Lösch-Gebiet DCG leicht von dem Löschkontakt CL zurückgezogen.

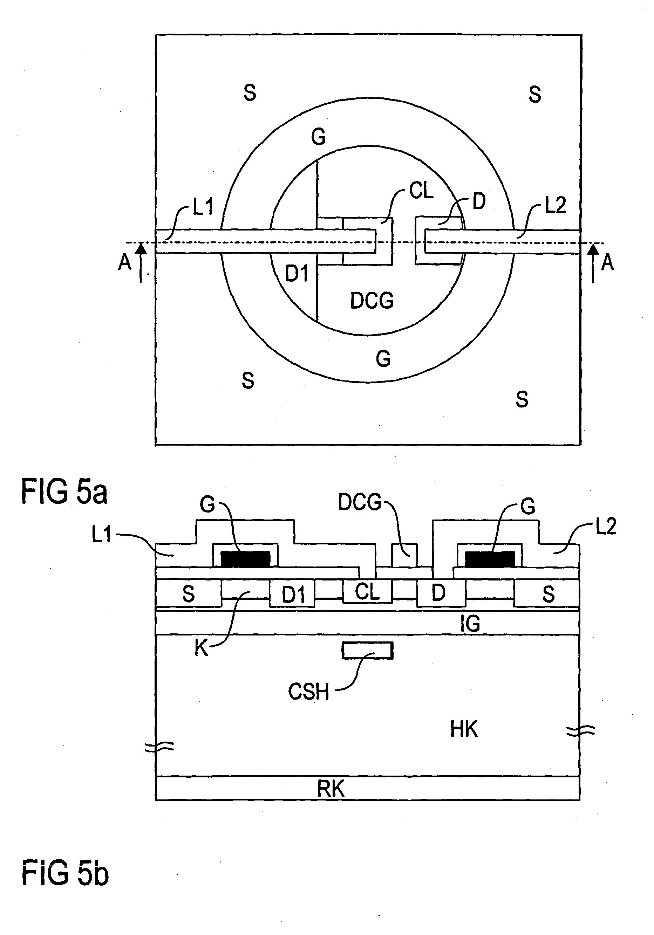

Das in den Figuren 5a und 5b dargestellte Ausführungsbeispiel einer erfindungsgemäßen ringförmigen DEPFET-Struktur stimmt ebenfalls weitgehend mit dem vorstehend beschriebenen und in den Figuren 3a und 3b dargestellten Ausführungsbeispiel überein, so dass zur Vermeidung von Wiederholungen weitgehend auf die vorstehende Beschreibung verwiesen wird und im Folgenden für entsprechende Bauteile dieselben Bezugszeichen verwendet werden.

Eine Besonderheit dieses Ausführungsbeispiels besteht darin, dass zusätzlich zu dem Drain-Gebiet D ein weiteres Drain-Gebiet D1 vorgesehen ist, wobei die beiden Drain-Gebiete D, D1 direkt an das ringförmige Gate-Gebiet G angrenzen. Das direkte Heranführen der Drain-Gebiete D, D1 bis an das Gate-Gebiet G bietet den Vorteil, dass eine Überquerung dieser Gebiete mit Leiterbahnen beliebiger Spannungen möglich ist, ohne die Eigenschaften der DEPFET-Struktur wesentlich zu beeinflussen. So ist der mittig angeordnete Löschkontakt CL hierbei durch eine Leitungsüberführung L1 kontaktiert, während das Drain-Gebiet D durch eine Leitungsüberführung L2 kontaktiert wird.

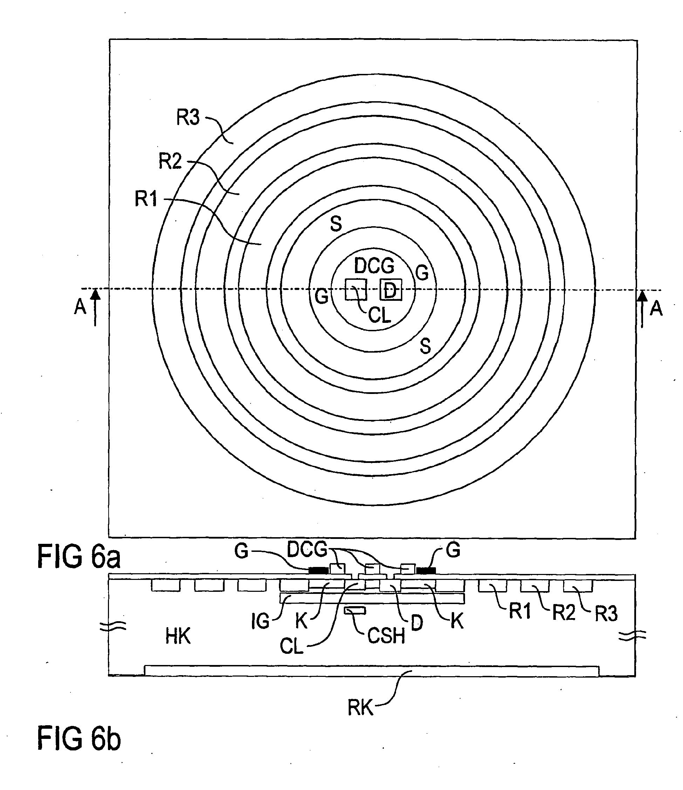

Die Figuren 6a und 6b zeigen einen vollständigen Driftdetektor mit mehreren Ringelektroden R1, R2, R3 zur Erzeugung eines Driftfeldes in dem Halbleiterkörper HK, wobei in dem Driftdetektor mittig eine DEPFET-Struktur angeordnet ist, wie sie vorstehend unter Bezugnahme auf die Figuren 3a und 3b beschrieben wurde. Hinsichtlich des weiteren Aufbaus und der Funktionsweise des Driftdetektors wird zur Vermeidung von Wiederholungen auf die bereits vorstehend zitierten Druckschriften L. STRÜDER: "Nuclear Instruments and Methods in Physics Research A", Bd. 454, 2000, DE 34 27 476 A1 und DE 102 13 812 A1 verwiesen, wobei der Inhalt dieser Druckschriften der vorliegenden Beschreibung in vollem Umfang zuzurechnen ist.

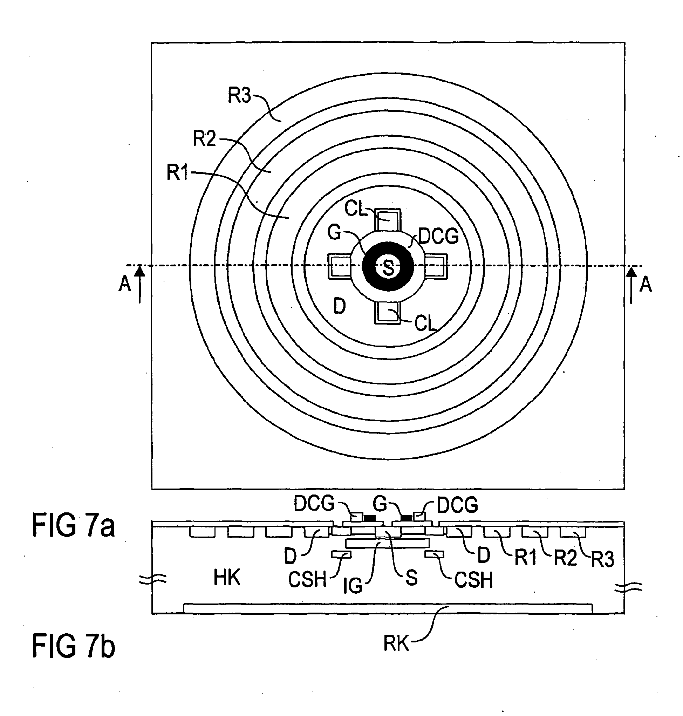

Die Figuren 7a und 7b zeigen schließlich ein alternatives Ausführungsbeispiel eines derartigen Driftdetektors, das im Wesentlichen mit dem vorstehend beschriebenen und in den Figuren 6a und 6b dargestellten Driftdetektor übereinstimmt, so dass zur Vermeidung von Wiederholungen auf die zugehörige Beschreibung verwiesen wird und im Folgenden für entsprechende Bauteile dieselben Bezugszeichen verwendet werden.

Eine Besonderheit dieses Ausführungsbeispiels besteht darin, dass vier separate und zueinander beabstandete Löschkontakte CL vorgesehen sind. Dies bietet den Vorteil, dass der mittlere Abstand zwischen den aus dem inneren Gate-Gebiet IG abzusaugenden Signalelektronen und dem jeweils nächstgelegenen Löschkontakt CL verringert wird, was kürzere Löschzeiten ermöglicht.

Darüber hinaus ermöglicht die Anordnung des Source-Gebiets S im Zentrum der ringförmigen Struktur eine Verkleinerung des inneren Gate-Gebiets IG, wodurch die Verstärkung und das Rauschverhalten verbessert werden.

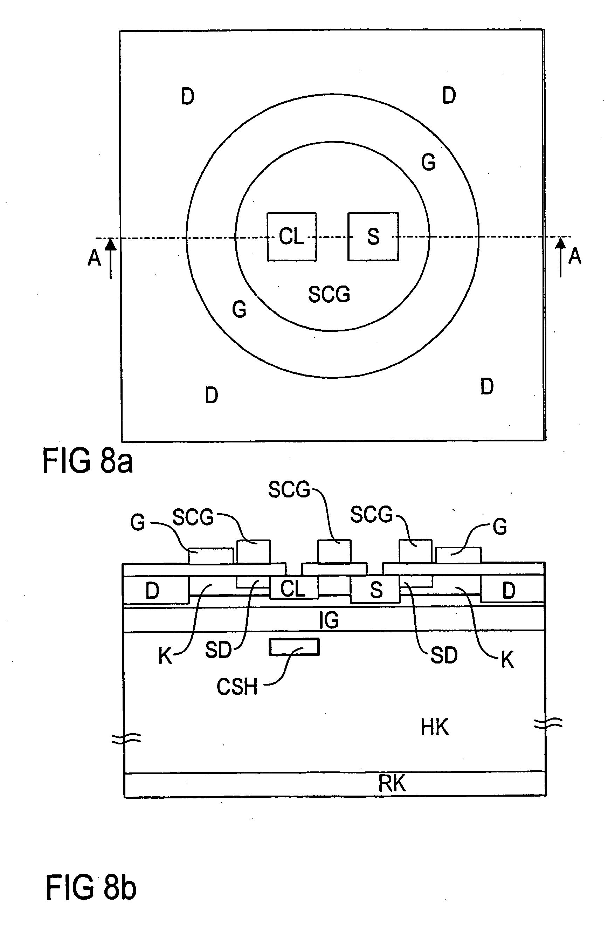

Die Figuren 8a und 8b zeigen ein weiteres Ausführungsbeispiel einer erfindungsgemäßen ringförmigen DEPFET-Sruktur, das weitgehend mit dem vorstehend beschriebenen und in den Figuren 3a und 3b beschriebenen Ausführungsbeispiel übereinstimmt, so dass zur Vermeidung von Wiederholungen weitgehend auf die vorstehende Beschreibung verwiesen wird und im Folgenden für entsprechende Bauteile dieselben Bezugszeichen verwendet werden.

Dieses Ausführungsbeispiel weist gegenüber dem Ausführungsbeispiel gemäß den Figuren 3a und 3b jedoch im Wesentlichen drei Unterschiede auf, die im folgenden kurz beschrieben werden.

Zum einen ist das Drain-Gebiet D mit dem Source-Gebiet S vertauscht. Diese Vertauschung kann zur Anpassung an eine externe Elektronik vorteilhaft sein.

Zum anderen ist anstelle des Drain-Lösch-Gebiets DCG ein Source-Lösch-Gebiet SCG vorgesehen, das jedoch im Wesentlichen dieselbe Funktion hat, wie das Drain-Lösch-Gebiet DCG bei dem Ausführungsbeispiel gemäß den Figuren 3a und 3b.

Darüber hinaus ist das Source-Lösch-Gebiet SCG bei diesem Ausführungsbeispiel mit einer zusätzlichen oberflächennahen Implantation SD unterlegt, wobei die Implantation SD p-dotiert ist. Die zusätzliche oberflächennahe Dotierung SD bewirkt eine Verschiebung der für den Betrieb der Struktur nötigen SCG-Spannungen. Man kann diese damit in einen günstigeren Bereich bringen. Dies ist insbesondere bei Anreicherungstypen nötig, da sonst die bei Silizium auftretenden positiven Ladungen im Strom-führenden Zustand eine hohe negative Spannung am SCG erfordern. Natürlich ist es auch möglich, für die Gate-Region eine analoge Maßnahme zu treffen.

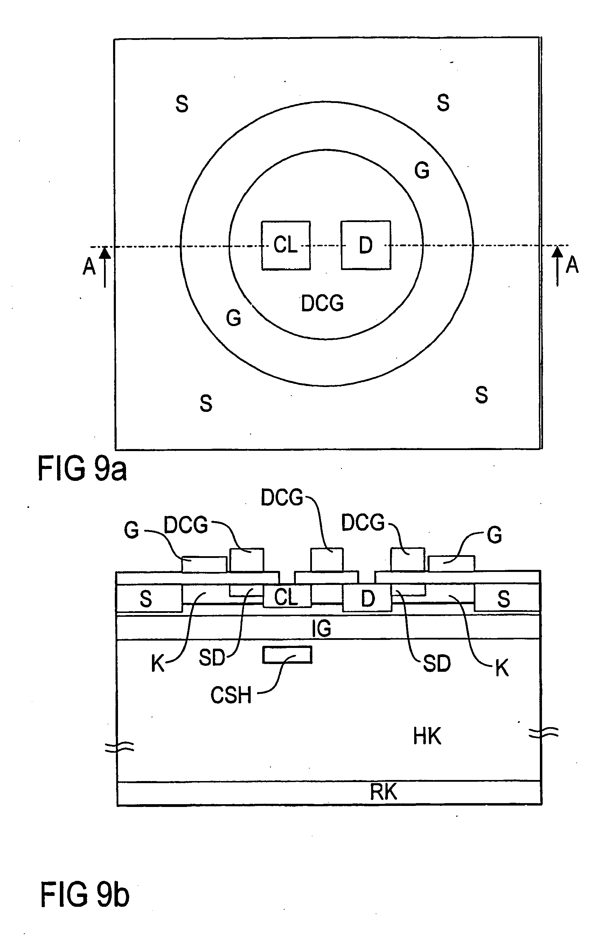

Die Figuren 9a und 9b zeigen ein weiteres Ausführungsbeispiel einer erfindungsgemäßen ringförmigen DEPFET-Sruktur, das weitgehend mit dem vorstehend beschriebenen und in den Figuren 8a und 8b beschriebenen Ausführungsbeispiel übereinstimmt, so dass zur Vermeidung von Wiederholungen weitgehend auf die vorstehende Beschreibung verwiesen wird und im Folgenden für entsprechende Bauteile dieselben Bezugszeichen verwendet werden.

Ein Unterschied gegenüber dem Ausführungsbeispiel gemäß den Figuren 8a und 8b besteht hierbei darin, dass das Source-Gebiet S und das Drain-Gebiet D nicht vertauscht sind. Das Source-Gebiet S und das Drain-Gebiet D sind hierbei also in der gleichen Weise angeordnet, wie bei dem Ausführungsbeispiel gemäß den Figuren 3a und 3b.

Entsprechend ist auch kein Source-Lösch-Gebiet SCG vorgesehen, sondern ein Drain Lösch-Gebiet DCG, wie bei dem Ausführungsbeispiel gemäß den Figuren 3a und 3b.

## Patentansprüche

1. Halbleiterstruktur, insbesondere in einem Halbleiterdetektor, mit
- einem schwach dotierten Halbleitersubstrat (HK) eines ersten oder zweiten Dotierungstyps,
- einem an einer ersten Oberfläche des Halbleitersubstrats (HK) angeordneten hochdotierten Drain-Gebiet (D, D1) eines zweiten Dotierungstyps,
- einem an der ersten Oberfläche des Halbleitersubstrats (HK) angeordneten hochdotierten Source-Gebiet (S) des zweiten Dotierungstyps,
- einem zwischen dem Source-Gebiet (S) und dem Drain-Gebiet (D, D1) verlaufenden Leitungskanal (K),
- einem in dem Halbleitersubstrat (HK) mindestens teilweise unter dem Leitungskanal (K) angeordneten dotierten inneren Gate-Gebiet (IG) des ersten Dotierungstyps und
- einem Löschkontakt (CL) zur Entfernung von Ladungsträgern aus dem inneren Gate-Gebiet (IG),
**dadurch gekennzeichnet, dass**
dass sich das innere Gate-Gebiet (IG) in dem Halbleitersubstrat (HK) mindestens teilweise bis zu dem Löschkontakt (CL) erstreckt.

2. Halbleiterstruktur nach Anspruch 1, **dadurch gekennzeichnet, dass** der Löschkontakt (CL) bezüglich des Source-Gebiets (S) drainseitig angeordnet ist.

3. Halbleiterstruktur nach Anspruch 1 oder 2, **dadurch gekennzeichnet, dass** der Löschkontakt (CL) mindestens teilweise zwischen dem Source-Gebiet (S) und dem Drain-Gebiet (D, D1) angeordnet ist.

4. Halbleiterstruktur nach einem der vorhergehenden Ansprüche, **gekennzeichnet durch** ein wahlweise als Hilfslöschkontakt oder als Drain ansteuerbares Drain-Lösch-Gebiet (DCG), das an den Löschkontakt (CL) und an das Drain-Gebiet (D, D1) angrenzt oder nahe an das Drain-Gebiet (D, D1) herangeführt ist.

5. Halbleiterstruktur nach einem der Ansprüche 1 bis 3, **gekennzeichnet durch** ein wahlweise als Hilfslöschkontakt oder als Source ansteuerbares Source-Lösch-Gebiet (SCG), das an den Löschkontakt (CL) und an das Source-Gebiet (S) angrenzt oder nahe an das Source-Gebiet (S) herangeführt ist.

6. Halbleiterstruktur nach einem der vorhergehenden Ansprüche, **dadurch gekennzeichnet, dass** in dem Halbleitersubstrat (HK) unter dem Löschkontakt (CL) ein dotiertes Abschirm-Gebiet (CSH) des zweiten Dotierungstyps angeordnet ist, das den Löschkontakt (CL) elektrisch abschirmt.

7. Halbleiterstruktur nach einem der vorhergehenden Ansprüche, **dadurch gekennzeichnet, dass** sich das innere Gate-Gebiet (IG) in dem Halbleitersubstrat (HK) von dem Source-Gebiet (S) bis zu dem Drain-Gebiet (D,D1) erstreckt.

8. Halbleiterstruktur nach einem der Ansprüche 1 bis 6, **dadurch gekennzeichnet, dass** das innere Gate-Gebiet (IG) in dem Halbleitersubstrat (HK) mindestens teilweise unter dem Drain-Gebiet (D, D1) und dem Löschkontakt (CL) angeordnet ist und zu dem Source-Gebiet (S) beabstandet ist.

9. Halbleiterstruktur nach einem der vorhergehenden Ansprüche, **dadurch gekennzeichnet, dass** der Leitungskanal (K) unmittelbar an den Löschkontakt (CL) angrenzt.

10. Halbleiterstruktur nach einem der Ansprüche 1 bis 8, **dadurch gekennzeichnet, dass** der Leitungskanal (K) bis auf einen vorgegebenen Abstand an den Löschkontakt (CL) herangeführt ist.

11. Halbleiterstruktur nach einem der vorhergehenden Ansprüche, **dadurch gekennzeichnet, dass** das Drain-Gebiet (D, D1) in mehrere zueinander beabstandete Teilgebiete aufgeteilt ist.

12. Halbleiterstruktur nach Anspruch 11, **dadurch gekennzeichnet, dass** ein erste Teilgebiet des Drain-Gebiets (D, D1) direkt kontaktiert ist, während ein zweites Teilgebiet des Drain-Gebiets (D, D1) über eine Inversionsschicht unter dem Drain-Lösch-Gebiet (DCG) kontaktiert wird.

13. Halbleiterstruktur nach einem der vorhergehenden Ansprüche, **gekennzeichnet durch** eine erste Leitungsüberführung (L2) zur Kontaktierung des Drain-Gebiets (D, D1).

14. Halbleiterstruktur nach einem der vorhergehenden Ansprüche, **gekennzeichnet durch** eine zweite Leitungsüberführung (L1) zur Kontaktierung des Lösch-Kontakts.

15. Halbleiterstruktur nach einem der vorhergehenden Ansprüche, **dadurch gekennzeichnet, dass** zur Steuerung des Leitungskanals (K) ein geschlossenes und/oder ringförmiges Gate-Gebiet (G) vorgesehen ist.

16. Halbleiterstruktur nach Anspruch 15, **dadurch gekennzeichnet, dass** der Löschkontakt (CL) und/oder das Drain-Gebiet (D, D1) und/oder das Drain-Lösch-Gebiet (DCG) innerhalb des Gate-Gebiets (G) angeordnet sind, während das Source-Gebiet (S) außerhalb des Gate-Gebiets (G) angeordnet ist.

17. Halbleiterstruktur nach Anspruch 15, **dadurch gekennzeichnet, dass** der Löschkontakt (CL) und/oder das Drain-Gebiet (D, D1) und/oder das Drain-Lösch-Gebiet (DCG) außerhalb des Gate-Gebiets (G) angeordnet sind, während das Source-Gebiet (S) innerhalb des Gate-Gebiets (G) angeordnet ist.

18. Halbleiterstruktur nach einem der Ansprüche 15 bis 17, **dadurch gekennzeichnet, dass** das Drain-Lösch-Gebiet (DCG) an den gesamten Umfang des Gate-Gebiets (G) anschließt.

19. Halbleiterstruktur nach einem der Ansprüche 15 bis 18, **dadurch gekennzeichnet, dass** das Gate-Gebiet (G) nur mit einem Teil des Umfangs an das Drain-Lösch-Gebiet (DCG) und mit dem Rest des Umfangs an ein dotiertes Gebiet des zweiten Dotierungstyps angrenzt, das mit dem Drain-Gebiet (D, D1) verbunden ist und/oder an das Drain-Gebiet (D, D1) angrenzt.

20. Halbleiterstruktur nach einem der vorhergehenden Ansprüche, **dadurch gekennzeichnet, dass** der Löschkontakt (CL) in mehrere Teile aufgeteilt ist.

21. Halbleiterstruktur nach einem der vorhergehenden Ansprüche, **dadurch gekennzeichnet, dass** an einer zweiten Oberfläche des Halbleitersubstrats (HK) ein Gebiet (RK) des zweiten Dotierungstyps angeordnet ist, um das Halbleitersubstrat (HK) zu verarmen.

22. Halbleiterstruktur nach einem der vorhergehenden Ansprüche, **dadurch gekennzeichnet, dass** der erste Dotierungstyp n-dotiert ist, wohingegen der zweite Dotierungstyp p-dotiert ist.

23. Halbleiterstruktur nach einem der Ansprüche 1 bis 21, **dadurch gekennzeichnet, dass** der erste Dotierungstyp p-dotiert ist, wohingegen der zweite Dotierungstyp n-dotiert ist.

24. Halbleiterstruktur nach einem der vorhergehenden Ansprüche, **dadurch gekennzeichnet, dass** das Halbleitersubstrat (HK) Silizium ist.

25. Halbleiterstruktur nach einem der vorhergehenden Ansprüche, **dadurch gekennzeichnet, dass** das Drain-Lösch-Gebiet (DCG) ein MOS-Gebiet ist.

26. Halbleiterstruktur nach einem der vorhergehenden Ansprüche, **gekennzeichnet durch** die Ausbildung als Verarmungstyp mit zusätzlicher Kanalimplantation.

27. Halbleiterstruktur nach einem der vorhergehenden Ansprüche, **gekennzeichnet durch** die Ausbildung als Anreicherungstyp ohne zusätzliche Kanalimplantation.

28. Halbleiterstruktur nach einem der Ansprüche 4 bis 27, **dadurch gekennzeichnet, dass** das Drain-Lösch-Gebiet (DCG) oder das Source-Lösch-Gebiet (SCG) mit einer oberflächennahen Implantation (SD) des zweiten Dotierungstyps unterlegt ist.

29. Detektor, insbesondere Driftdetektor, mit einer Halbleiterstruktur nach einem der vorhergehenden Ansprüche.

## Claims

1. Semiconductor structure, in particular in a semiconductor detector, comprising
- a weakly doped semiconductor substrate (HK) of a first or second doping type,
- a highly doped drain region (D, D1) of a second doping type, located on a first surface of the semiconductor substrate (HK),
- a highly doped source region (S) of the second doping type, located on the first surface of the semiconductor substrate (HK),
- a duct (K) extending between the source region (S) and the drain region (D, D 1)
- a doped inner gate region (IG) of the first doping type, which is at least partially located below the duct (K), and
- a blow-out contact (CL) for removing charge carriers from the inner gate region (IG),
**characterised in that** the inner gate region (IG) extends within the semiconductor substrate (HK) at least partially up to the blow-out contact (CL).

2. Semiconductor structure according to claim 1, **characterised in that** the blow-out contact (CL) is located on the drain side relative to the source region (S).

3. Semiconductor structure according to either claim 1 or claim 2, **characterised in that** the blow-out contact (CL) is located at least in part between the source region (S) and the drain region (D, D1).

4. Semiconductor structure according to any one of the preceding claims, **characterised by** a drain discharge region (DCG) which is optionally able to be activated as an auxiliary blow-out contact or as a drain and which adjoins the blow-out contact (CL) and the drain region (D, D1) or is introduced close to the drain region (D, D1).

5. Semiconductor structure according to any one of claims 1 to 3, **characterised by** a source discharge region (SCG) which is optionally able to be activated as an auxiliary blow-out contact or as a source and which adjoins the blow-out contact (CL) and the source region (S) or is introduced close to the source region (S).

6. Semiconductor structure according to any one of the preceding claims, **characterised in that** a doped insulating region (CSH) of the second doping type, which electrically insulates the blow-out contact (CL), is located in the semiconductor substrate (HK), under the blow-out contact (CL).

7. Semiconductor structure according to any one of the preceding claims, **characterised in that** the inner gate region (IG) extends within the semiconductor substrate (HK) from the source region (S) up to the drain region (D, D1).

8. Semiconductor structure according to any one of claims 1 to 6, **characterised in that** the inner gate region (IG) is located in the semi-conductor substrate (HK) at least partially under the drain region (D, D1) and the blow-out contact (CL) and is spaced apart from the source region (S).

9. Semiconductor structure according to any one of the preceding claims, **characterised in that** the duct (K) is directly adjacent to the blow-out contact (CL).

10. Semiconductor structure according to any one of claims 1 to 8, **characterised in that** the duct (K) is introduced on the blow-out contact (CL) up to a preset distance.

11. Semiconductor structure according to any one of the preceding claims, **characterised in that** the drain region (D,D1) is divided into a plurality of partial regions arranged at a distance from one another.

12. Semiconductor structure according to claim 11, **characterised in that** a first partial region of the drain region (D, D1) is contacted directly, whilst a second partial region of the drain region (D, D1) is contacted via an inversion layer under the drain discharge region (DCG).

13. Semiconductor structure according to any one of the preceding claims, **characterised by** a first conductor crossover (L2) for contacting the drain region (D, D1).

14. Semiconductor structure according to any one of the preceding claims, **characterised by** a second conductor crossover (L1) for contacting the blow-out contact.

15. Semiconductor structure according to any one of the preceding claims, **characterised in that** a closed and/or annular gate-region (G) is provided for controlling the duct (K).

16. Semiconductor structure according to claim 15, **characterised in that** the blow-out contact (CL) and/or the drain region (D, D1) and/or the drain discharge region (DCG) are located inside the gate region (G), whilst the source region (S) is located outside the gate region (G).

17. Semiconductor structure according to claim 15, **characterised in that** the blow-out contact (CL) and/or the drain region (D, D1) and/or the drain discharge region (DCG) are located outside the gate region (G), whilst the source region (S) is located inside the gate region (G).

18. Semiconductor structure according to any one of claims 15 to 17, **characterised in that** the drain discharge region (DCG) adjoins the whole periphery of the gate region (G).

19. Semiconductor structure according to any one of claims 15 to 18, **characterised in that** only a part of the periphery of the gate region (G) is adjacent to the drain discharge region (DCG) and the rest of said periphery is adjacent to a doped region of the second doping type, which is connected to the drain region (D,D1) and/or is adjacent to the drain region (D,D1).

20. Semiconductor structure according to any one of the preceding claims, **characterised in that** the blow-out contact (CL) is divided into a plurality of parts.

21. Semiconductor structure according to any one of the preceding claims, **characterised in that** a region (RK) of the second doping type is located on a second surface of the semiconductor substrate (HK) in order to deplete the semiconductor substrate (HK).

22. Semiconductor structure according to any one of the preceding claims, **characterised in that** the first doping type is n-doped, whereas the second doping type is p-doped.

23. Semiconductor structure according to any one of claims 1 to 21, **characterised in that** the first doping type is p-doped, whereas the second doping type is n-doped.

24. Semiconductor structure according to any one of the preceding claims, **characterised in that** the semiconductor substrate (HK) is silicon.

25. Semiconductor structure according to any one of the preceding claims, **characterised in that** the drain discharge region (DCG) is an MOS-region.

26. Semiconductor structure according to any one of the preceding claims, **characterised by** the configuration as a depletion type with additional channel implantation.

27. Semiconductor structure according to any one of the preceding claims, **characterised by** the configuration as an enhancement type without additional channel implantation.

28. Semiconductor structure according to any one of claims 4 to 27, **characterised in that** the drain discharge region (DCG) or the source discharge region (SCG) is underlaid with a near-surface implantation (SD) of the second doping type.

29. Detector, in particular drift detector, comprising a semiconductor structure according to any one of the preceding claims.

## Revendications

1. Structure à semi-conducteur, en particulier dans un détecteur à semi-conducteurs, comportant
- un substrat semi-conducteur (HK) faiblement dopé selon un premier ou un deuxième type de dopage,
- une zone de drain (D, D1) fortement dopée selon un deuxième type de dopage, disposée sur une première surface du substrat semi-conducteur (HK),
- une zone de source (S) fortement dopée selon un deuxième type de dopage, disposée sur la première surface du substrat semi-conducteur (HK),
- un conduit de câble (K) qui s'étend entre la zone de source (S) et la zone de drain (D, D1),
- une zone de grille (IG) intérieure, dopée selon le premier type de dopage, disposée dans le substrat semi-conducteur (HK) au moins partiellement en dessous du conduit de câble (K), et
- un contact de désamorçage (CL) pour éliminer les porteurs de charge hors de la zone de grille (IG) intérieure,
**caractérisée en ce que** la zone de grille (IG) intérieure s'étend dans le substrat semi-conducteur (HK) au moins partiellement jusqu'au contact de désamorçage (CL).

2. Structure à semi-conducteur selon la revendication 1, **caractérisée en ce que** le contact de désamorçage (CL) est disposé du côté drain par rapport à la zone de source (S).

3. Structure à semi-conducteur selon la revendication 1 ou 2, **caractérisée en ce que** le contact de désamorçage (CL) est disposé au moins partiellement entre la zone de source (S) et la zone de drain (D, D1).

4. Structure à semi-conducteur selon l'une quelconque des revendications précédentes, **caractérisée par** une zone de drain et de désamorçage (DCG), qui peut être activée au choix sous forme de contact de désamorçage auxiliaire ou sous forme de drain et qui est adjacente au contact de désamorçage (CL) et à la zone de drain (D, D1) ou est amenée à proximité de la zone de drain (D, D1).

5. Structure à semi-conducteur selon l'une quelconque des revendications 1 à 3, **caractérisée par** une zone de source et de désamorçage (SCG), qui peut être activée au choix sous forme de contact de désamorçage auxiliaire ou sous forme de source et qui est adjacente au contact de désamorçage (CL) et à la zone de source (S) ou est amenée à proximité de la zone de source (S).

6. Structure à semi-conducteur selon l'une quelconque des revendications précédentes, **caractérisée en ce qu'**une zone de protection (CSH) dopée selon le deuxième type de dopage, laquelle protège électriquement le contact de désamorçage (CL), est agencée dans le substrat semi-conducteur (HK) en dessous du contact de désamorçage (CL).

7. Structure à semi-conducteur selon l'une quelconque des revendications précédentes, **caractérisée en ce que** la zone de grille (IG) intérieure s'étend dans le substrat semi-conducteur (HK) depuis la zone de source (S) vers la zone de drain (D, D1).

8. Structure à semi-conducteur selon l'une quelconque des revendications 1 à 6, **caractérisée en ce que** la zone de grille (IG) intérieure est disposée dans le substrat semi-conducteur (HK) au moins partiellement en dessous de la zone de drain (D, D1) et du contact de désamorçage (CL) et est située à distance de la zone de source (S).

9. Structure à semi-conducteur selon l'une quelconque des revendications précédentes, **caractérisée en ce que** le conduit de câble (K) est directement adjacent au contact de désamorçage (CL).

10. Structure à semi-conducteur selon l'une quelconque des revendications 1 à 8, **caractérisée en ce que** le conduit de câble (K) mène jusqu'à une distance prédéfinie du contact de désamorçage (CL).

11. Structure à semi-conducteur selon l'une quelconque des revendications précédentes, **caractérisée en ce que** la zone de drain (D, D1) est divisée en plusieurs zones partielles situées à distance les unes des autres.

12. Structure à semi-conducteur selon la revendication 11, **caractérisée en ce qu'**une première zone partielle de la zone de drain (D, D1) est mise en contact directement, alors qu'une deuxième zone partielle de la zone de drain (D, D1) est mise en contact par l'intermédiaire d'une couche d'inversion en dessous de la zone de drain et de désamorçage (DCG).

13. Structure à semi-conducteur selon l'une quelconque des revendications précédentes, **caractérisée par** une première interconnexion de lignes (L2) pour la mise en contact de la zone de drain (D, D1).

14. Structure à semi-conducteur selon l'une quelconque des revendications précédentes, **caractérisée par** une deuxième interconnexion de lignes (L1) pour la mise en contact du contact de désamorçage.

15. Structure à semi-conducteur selon l'une quelconque des revendications précédentes, **caractérisée en ce qu'**il est prévu une zone de grille (G) fermée et/ou annulaire pour commander le conduit de câble (K).

16. Structure à semi-conducteur selon la revendication 15, **caractérisée en ce que** le contact de désamorçage (CL) et/ou la zone de drain (D, D1) et/ou la zone de drain et de désamorçage (DCG) sont disposées à l'intérieur de la zone de grille (G), tandis que la zone de source (S) est disposée à l'extérieur de la zone de grille (G).

17. Structure à semi-conducteur selon la revendication 15, **caractérisée en ce que** le contact de désamorçage (CL) et/ou la zone de drain (D, D1) et/ou la zone de drain et de désamorçage (DCG) sont disposées à l'extérieur de la zone de grille (G), tandis que la zone de source (S) est disposée à l'intérieur de la zone de grille (G).

18. Structure à semi-conducteur selon l'une quelconque des revendications 15 à 17, **caractérisée en ce que** la zone de drain et de désamorçage (DCG) est adjacente à tout le pourtour de la zone de grille (G).

19. Structure à semi-conducteur selon l'une quelconque des revendications 15 à 18, **caractérisée en ce que** la zone de grille (G) est adjacente seulement avec une partie de son pourtour à la zone de drain et de désamorçage (DCG) et avec le reste de son pourtour est adjacente à une zone dopée selon le deuxième type de dopage, laquelle est reliée à la zone de drain (D, D1) et/ou est adjacente à la zone de drain (D, D1).

20. Structure à semi-conducteur selon l'une quelconque des revendications précédentes, **caractérisée en ce que** le contact de désamorçage (CL) est divisé en plusieurs parties.

21. Structure à semi-conducteur selon l'une quelconque des revendications précédentes, **caractérisée en ce que** sur une deuxième surface du substrat semi-conducteur (HK) est disposée une zone (RK) du deuxième type de dopage, afin d'appauvrir le substrat semi-conducteur (HK).

22. Structure à semi-conducteur selon l'une quelconque des revendications précédentes, **caractérisée en ce que** le premier type de dopage est dopé n, alors que le deuxième type de dopage est dopé p.

23. Structure à semi-conducteur selon l'une quelconque des revendications 1 à 21, **caractérisée en ce que** le premier type de dopage est dopé p, alors que le deuxième type de dopage est dopé n.

24. Structure à semi-conducteur selon l'une quelconque des revendications précédentes, **caractérisée en ce que** le substrat semi-conducteur (HK) est du silicium.

25. Structure à semi-conducteur selon l'une quelconque des revendications précédentes, **caractérisée en ce que** la zone de drain et de désamorçage (DCG) est une zone MOS.

26. Structure à semi-conducteur selon l'une quelconque des revendications précédentes, **caractérisée par** la réalisation sous forme de type de déplétion avec une implantation supplémentaire de conduit.

27. Structure à semi-conducteur selon l'une quelconque des revendications précédentes, **caractérisée par** la réalisation sous forme de type d'enrichissement sans implantation supplémentaire de conduit.

28. Structure à semi-conducteur selon l'une quelconque des revendications 4 à 27, **caractérisée en ce qu'**en dessous de la zone de drain et de désamorçage (DCG) ou de la zone de source et de désamorçage (SCG) est posée une implantation (SD) du deuxième type de dopage, proche de la surface.

29. Détecteur, en particulier détecteur de dérive, avec une structure à semi-conducteur selon l'une quelconque des revendications précédentes.
